# EUROPÄISCHE PATENTSCHRIFT

(11) **EP 0 799 096 B1**
(45) Veröffentlichungstag und Bekanntmachung des Hinweises auf die Patenterteilung: **11.07.2001**
(21) Anmeldenummer: 95913085.7
(22) Anmeldetag: 11.03.1995
(51) Int. Cl.: B05C 9/02, H01L 21/00

(54) **VERFAHREN UND VORRICHTUNG ZUR BELACKUNG ODER BESCHICHTUNG EINES SUBSTRATS**
PROCESS AND DEVICE FOR LACQUERING OR COATING A SUBSTRATE
PROCEDE ET DISPOSITIF DE LAQUAGE OU D'ENDUCTION D'UN SUBSTRAT

(30) Priorität: 22.12.1994 DE 4445985
(43) Veröffentlichungstag der Anmeldung: 08.10.1997
(60) Teilanmeldung: 99120202.9
(73) Patentinhaber: Steag HamaTech AG, 75447 Sternenfels (DE)
(72) Erfinder: APPICH, Karl, D-75447 Sternenfels (DE); STUMMER, Manfred, D-74889 Sinsheim (DE)
(86) Internationale Anmeldenummer: EP9500905
(87) Internationale Veröffentlichungsnummer: WO9619295

(56) Entgegenhaltungen:
- WO-A-94/25177
- DE-A- 2 204 625
- US-A- 2 046 596

## Beschreibung

Die Erfindung betrifft ein Verfahren und eine Vorrichtung zur Belackung oder Beschichtung eines Substrats mittels eines Kapillarspalts. Wenn im folgenden bei der Beschreibung der Erfindung vereinfachend nur von Belackung bzw. von Belackungsvorgängen gesprochen wird, so sind damit auch Beschichtung bzw. Beschichtungsvorgänge mit geeigneten Fluiden gemeint, also mit geeigneten Lacken oder geeigneten Beschichtungsflüssigkeiten.

Im Bereich der Dünnschichttechnik, insbesondere bei der Herstellung von LCD-Bildschirmen, von Masken für die Halbleiterfertigung, Halbleiter- oder Keramiksubstraten etc. ergibt sich häufig die Aufgabe, rechteckige oder runde Platten mit einer gleichmässigen Schicht aus Lack oder anderen zunächst flüssigen Medien zu versehen, z.B. mit Farbfiltern, Fotolacken, oder mit speziellen Schutzschichten. Nach dem Stand der Technik werden dabei die Platten zur Belackung horizontal auf einem Drehteller befestigt. Auf den Mittelpunkt der Platte wird von oben über eine Düse eine bestimmte Lackmenge aufgetropft. Danach wird der Drehteller in Bewegung gesetzt. Durch die Zentrifugalkraft wird der Lack während der Drehbewegung auf dem Substrat verteilt ("spin coating"). Dabei wird ein grosser Teil des Lackes über den Rand des Substrats weggeschleudert. Die erreichbare Gleichförmigkeit der Lackdicke hängt von der Grösse der Drehbeschleunigung, der Drehgeschwindigkeit, sowie von der Viskosität des Lackes ab.

Schwierigkeiten mit der Gleichförmigkeit der Lackdicke auf rechteckigen, plattenförmigen Substraten gibt es bei diesem bekannten Verfahren vor allem im Bereich der Ränder der Substrate. Dort bilden sich gewöhnlich Streifen höherer Lackdicke, nämlich sogenannte Lackwulste. Hierdurch wird die Gleichmässigkeit der Belackung wesentlich verschlechtert.

Um den Lack aufzufangen, der über den Rand des Substrates hinausgeschleudert wird, und um die Belackungsstation zu schützen, werden solche Belackungs-Drehteller gewöhnlich in eine Art Topf eingebaut, vgl. z.B. das DE-GM 91 03 494. Während des Belackens können Rückspritzer auch auf die Oberflächen der Substrate gelangen. Dies ist für die Weiterverarbeitung der Substrate ungünstig. Bei diesem bekannten Verfahren werden zudem bis über 90 % der verwendeten Lackmenge über den Rand der Substrate weggeschleudert; diese Lackmenge kann nur mit sehr hohem Aufwand wiederverwendet werden. Die Grösse der Platten, die belackt bzw. beschichtet werden können, ist nach oben hin begrenzt. Ferner können an den rotierenden Teilen solcher Vorrichtungen kleine Partikel abgerieben und abgelöst werden, die sich auf den Oberflächen der Platten ablagern und nachfolgende Prozesse stören. Ausserdem gelangt während des Schleuderprozesses Lack an die Substratkante, und das kann bei nachfolgenden Prozessen zu Problemen führen. Zudem ist der gesamte Aufbau und der Antrieb eines solchen Drehtellers aufwendig und teuer.

Eine Verbesserung der Belackungs- und Beschichtungsvorgänge wurde durch eine Vorrichtung zur Belackung und Beschichtung von Platten WO-9 425 177 erreicht, bei der die Belackungs- bzw. Beschichtungsflüssigkeit - im folgenden Fluid genannt - über einen zu einer Kapillare verengten Spalt von unten an die nach unten weisende Oberfläche eines Substrats herangeführt wird. Das Substrat wird mit gleichförmiger Geschwindigkeit über den Spalt hinweggeführt. Der Spalt ist so ausgebildet, dass er als Kapillare wirkt und somit den Lack selbsttätig und mit besonders gleichförmiger Geschwindigkeit nachliefert. Die Kapillarwirkung wird dadurch erreicht, dass der Spalt beispielsweise weniger als 0,5 mm breit ist. Durch die Kapillarwirkung steigt das Fluid selbsttätig mit konstanter Geschwindigkeit entgegen der Schwerkraft in dem Kapillarspalt nach oben und tritt an dessen Austrittsöffnung aus. Oberhalb des Spaltes trifft der Lackstrom als schmale Linie auf die zu beschichtende Fläche des Substrats und lagert sich, während das Substrat relativ zur Austrittsöffnung bewegt wird, auf dieser Fläche als gleichmässige Schicht ab.

Der Belackungs- bzw. Beschichtungsvorgang erfolgt damit durch eine kombinierte Ausnutzung von Kapillar- und Adhäsionseffekten. Mit dieser Vorrichtung lässt sich die Gleichmässigkeit der Lackschichtdicke insbesondere auf rechteckförmigen Substraten verbessern, und der Lackverbrauch nimmt ab. Nachteilig kann sich auf den Betrieb der Vorrichtung auswirken, dass das Fluid in längeren Pausen zwischen einzelnen Belackungs- bzw. Beschichtungsvorgängen im Bereich der Austrittsöffnung des Kapillarspalts an- bzw. eintrocknet. Dies kann den nachfolgenden Belackungs- bzw. Beschichtungsvorgang sehr nachteilig beeinflussen. Nachteilig kann sich ausserdem auswirken, dass durch die Adhäsionswirkung an der Endkante des zu belackenden bzw. zu beschichtenden Substrats ein unerwünschter Wulst aus Lack oder Beschichtungsmaterial entsteht.

Eine Aufgabe der vorliegenden Erfindung wird darin gesehen, eine neue Vorrichtung und ein neues Verfahren zur Belackung und Beschichtung von Substraten bereitzustellen.

Nach der Erfindung wird diese Aufgabe gelöst durch eine Vorrichtung zur Belackung oder Beschichtung eines Substrats mittels eines einen Kapillarspalt aufweisenden Bauteils, mit einem Lack oder Beschichtungsflüssigkeit - im folgenden Fluid genannt - enthaltenden Behälter, in welchem das Bauteil so angeordnet ist, dass der Kapillarspalt mit dem Fluid im Behälter in Verbindung steht und dieses Fluid dem Kapillarspalt zuführbar ist, und mit Mitteln zur Bewegung der Austrittsöffnung des Kapillarspalts relativ zum Behälter in Höhenrichtung. Die Beweglichkeit der Austrittsöffnung ermöglicht es, diese zu Beginn einer Belackung an ein Substrat besonders eng heranzuführen, und sie am Ende der Belackung wieder vom Substrat wegzuführen.

Dabei geht man mit besonderem Vorteil so vor, dass die Austrittsöffnung des Kapillarspalts durch eine in Höhenrichtung erfolgende Bewegung vollständig in das Fluid eintauchbar ist. Man kann so in den Zeiten zwischen Belackungsvorgängen die Austrittsöffnung des Kapillarspalts vollständig in das Fluid eintauchen. Dadurch wird verhindert, dass eventuelle Fluidreste, die von einem Belackungsvorgang an oder auf dem Kapillarspalt zurückgeblieben sind, antrocknen, und dass sich dort Partikel von aussen anlagern. Beides kann zu Störungen während eines späteren Belackungsvorganges führen.

Bei einer anderen, äusserst vorteilhaften Weiterbildung der Erfindung ist eine Verschlussvorrichtung für den Behälter vorgesehen, um diesen bei Nichtbenutzung der Vorrichtung nach aussen hin zu verschliessen. Damit wird jeglicher Trocknungsvorgang der gesamten Fluidmenge unterbunden, wozu die Verschlussvorrichtung bevorzugt luftdicht ausgebildet ist.

Auch hat es sich als sehr vorteilhaft erwiesen, eine Filtervorrichtung und eine Pumpe vorzusehen, um im Behälter befindliches Fluid im Umlauf zu filtrieren. Man kann so über ein Feinstpartikelfilter das Fluid filtrieren (Umlauffiltration), um es sauber und in einem für die Belackungszwecke geeigneten Zustand zu erhalten. Dabei ist mit Vorteil die Filtrierung während eines Beschichtungs- oder Belackungsvorganges unterbrochen.

Insbesondere zur Verhinderung eines Lackwulstes an der Endkante eines belackten bzw. beschichteten Substrats sind in vorteilhafter Weise Mittel vorgesehen, um das Niveau des Fluids im Behälter rasch abzusenken, besonders am Ende eines Belackungs- oder Beschichtungsvorganges. Durch diese Niveauabsenkung wird das Fluid schnell in den Kapillarspalt zurückgesaugt, so dass die Entstehung eines Wulstes an einer Endkante des Substrats reduziert oder vermieden werden kann.

Besonders vorteilhaft lässt sich ein solches Zurücksaugen des Fluids dadurch erreichen, dass in dem im Behälter befindlichen Fluid ein Bauteil angeordnet ist, dessen Volumen veränderbar ist. Wird dieses Volumen verkleinert, so sinkt der Flüssigkeitsspiegel im Behälter ab. Dies erzeugt einen Unterdruck im Kapillarspalt, der das dort befindliche Fluid nach unten zurückzieht.

Ein Verfahren gemäss der Erfindung ist ein Verfahren zum Belacken oder Beschichten eines Substrats mittels eines über einen Kapillarspalt zugeführten Fluids, mit folgenden Schritten:
a) Zu Beginn eines Beschichtungs- oder Belackungsvorgangs wird die Austrittsöffnung des Kapillarspalts eng an die Unterseite des Substrats herangeführt, so dass das Fluid an der Austrittsöffnung in Kontakt mit dieser Unterseite kommt;
b) anschliessend wird der Abstand zwischen dieser Austrittsöffnung und der Unterseite des Substrats auf einen für die Belackung oder Beschichtung ausreichenden Wert vergrössert.

Hierdurch wird der Beginn einer Belackung, und der Beginn eines Fluid-Transportvorgangs im Kapillarspalt, auf einfache Weise sichergestellt.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den Unteransprüchen. Es zeigt:
- Fig. 1: einen Querschnitt durch eine erfindungsgemässe Vorrichtung, bei der sich das einen Kapillarspalt bildende Bauteil in einem untergetauchten Zustand befindet,
- Fig. 2: einen Querschnitt durch die Vorrichtung der Fig. 1, bei der das den Kapillarspalt bildende Bauteil während eines Belackungsvorganges aus dem Fluid im Behälter herausgetaucht ist, gesehen längs der Linie II-II der Fig. 3,
- Fig. 3: einen Längsschnitt durch einen Teil einer erfindungsgemäßen Vorrichtung mit ausgetauchtem Kapillarspaltbauteil, während eines Belackungsvorganges,
- Fig. 4: eine teilweise im Schnitt dargestellte, raumbildliche Darstellung eines bevorzugten Ausführungsbeispiels einer erfindungsgemäßen Vorrichtung,
- Fig. 5: eine Einzelheit der Fig. 4, ebenfalls in raumbildlicher Darstellung,
- Fig. 6: einen Schnitt, gesehen längs der Linie VI-VI der Fig. 8, in einem gegenüber Fig. 6 vergrößerten Maßstab,
- Fig. 7: eine raumbildliche Darstellung der Einzelheit VII der Fig. 6,
- Fig. 8: einen Längsschnitt durch die in Fig. 4 dargestellte Vorrichtung,
- Fig. 9: eine raumbildliche Darstellung der in Fig. 4 dargestellten Vorrichtung, wobei sich der Kapillarspalt in seiner Arbeitsstellung befindet, gesehen von oben, und
- Fig. 10: eine raumbildliche Darstellung analog Fig. 9, aber gesehen von unten.

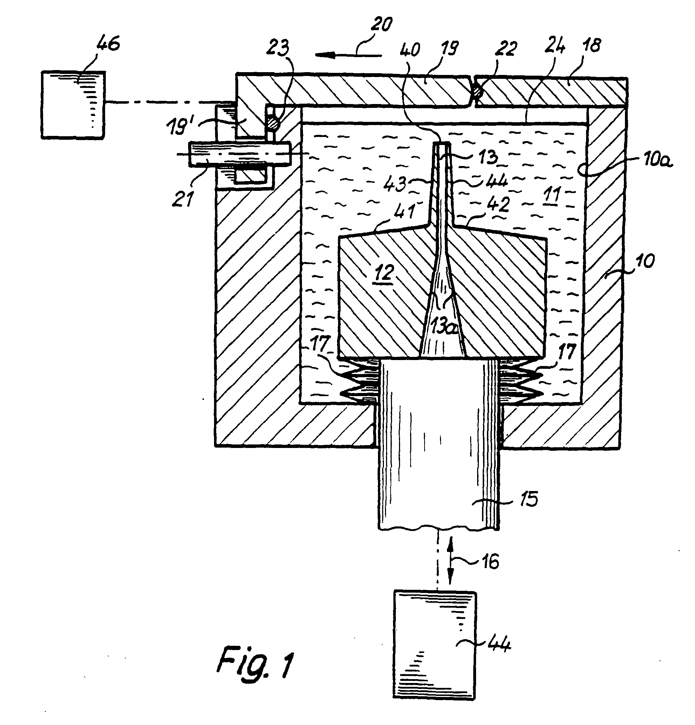

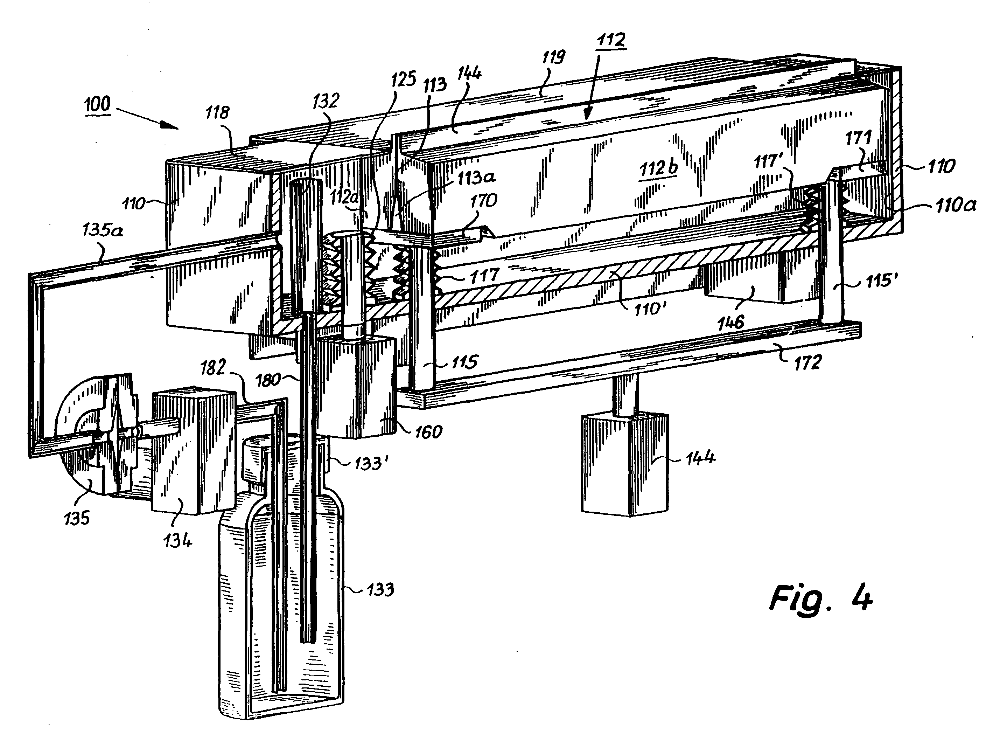

Zunächst wird anhand der Fig. 1 bis 3 das Grundprinzip der vorliegenden Erfindung an schematischen Darstellungen erläutert. Anschließend wird dann anhand der Fig. 4 bis 10 ein praktisches Ausführungsbeispiel der Erfindung dargestellt, das nach diesem Grundprinzip arbeitet.

Fig. 1 zeigt einen Schnitt durch einen Behälter 10, dessen Hohlraum 10a weitgehend mit Lack oder Beschichtungsmittel 11, im folgenden "Fluid" genannt, gefüllt ist. Im Behälter 10, der etwa die Form einer länglichen Rinne oder eines länglichen Troges hat, befindet sich ein längliches Bauteil 12, das einen für den Belackungsvorgang notwendigen Kapillarspalt 13 enthält. Dieser hat gewöhnlich eine Breite im Bereich von 0,1 bis 0,8 mm, und er wird durch einen senkrecht verlaufenden Schlitz im Bauteil 12 gebildet, der sich nach unten hin bei 13a erweitert, um das ungehinderte Zuströmen des Fluids 11 zum Kapillarspalt 13 zu ermöglichen.

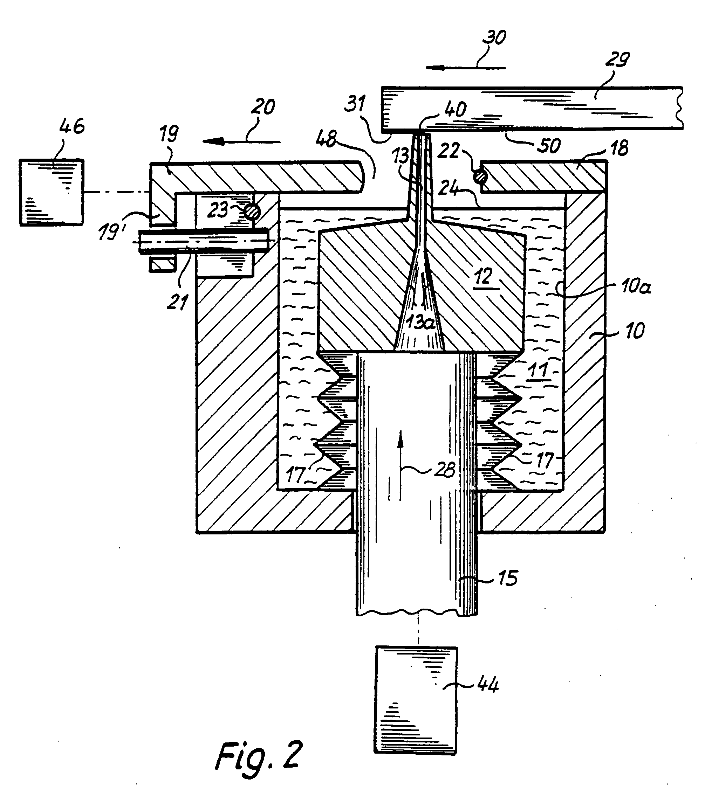

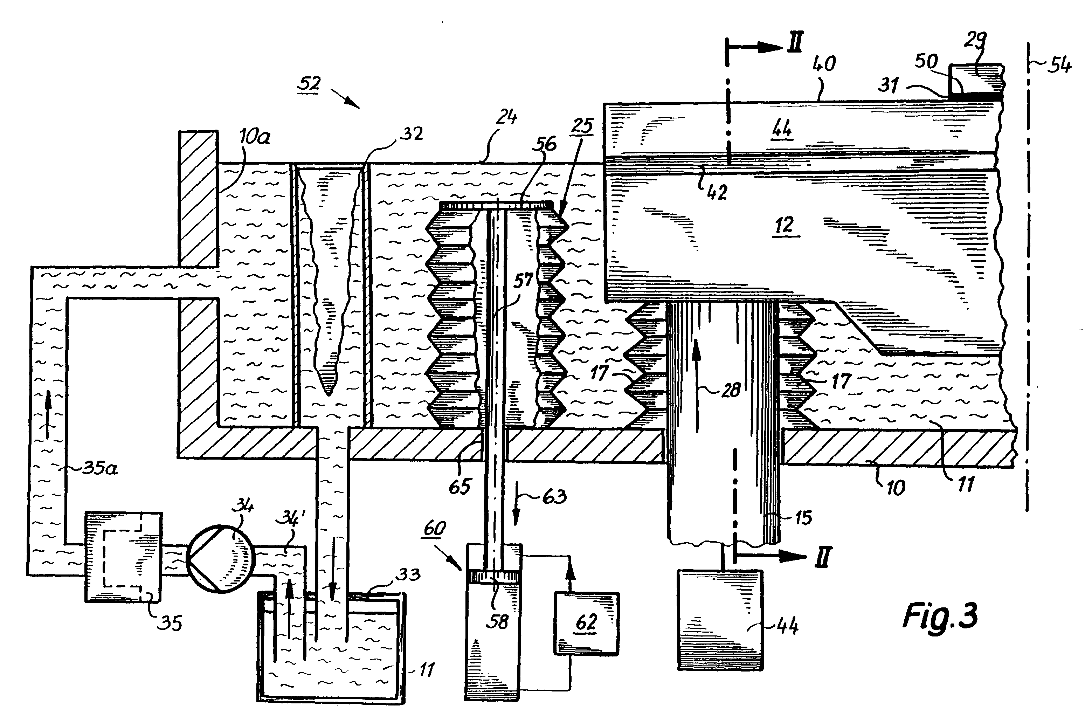

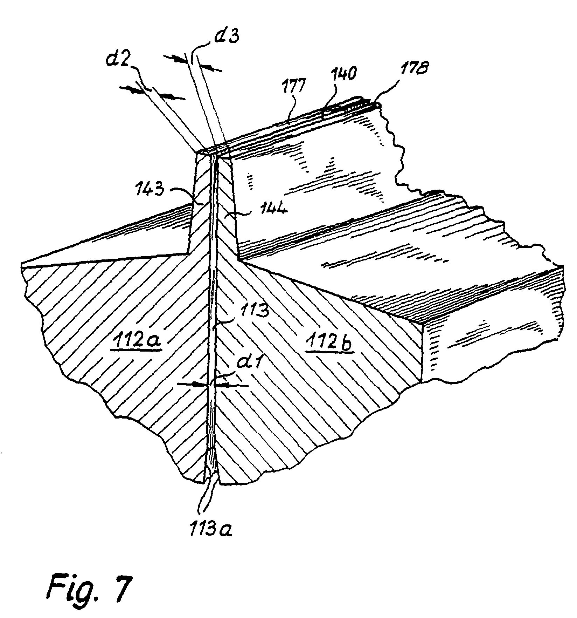

Am oberen Ende des Bauteils 12 hat der Kapillarspalt 13 eine Austrittsöffnung 40, die man auch als Düse bezeichnen könnte und die nachfolgend anhand der Fig. 7 noch im Detail dargestellt wird. Je nach der Breite eines zu beschichtenden Substrats 29 (Fig. 2 und 3) kann diese Austrittsöffnung 40 eine Länge im Bereich von z.B. 50 bis 75 cm haben, wobei naturgemäß auch längere oder kürzere Längen nicht ausgeschlossen sind.

Das Bauteil 12 hat im wesentlichen die Form eines im Querschnitt etwa rechteckförmigen Grundkörpers, der nach oben hin durch zwei schräg abfallende, dachartige Flächen 41, 42 begrenzt wird, und in dessen Mitte zwei messerartige Fortsätze 43, 44 nach oben ragen, von denen jeder im Bereich der Düse 40 nur eine Breite von etwa 0,1...0,5 mm hat. Diese Fortsätze 43, 4 verjüngen sich also nach oben hin und sind dort äußerst schmal.

Das Bauteil 12 ist an seiner Unterseite mit einer Stange 15 verbunden. Diese kann über eine nur schematisch dargestellte Vorrichtung 44 in Richtung eines Pfeiles 16 vertikal verschoben werden. Dadurch kann das Bauteil 12 in vertikaler Richtung bewegt werden. Der Hohlraum 10a des Behälters 10 ist gegen die Durchführung der Stange 15 durch seinen Boden in der dargestellten Weise mit einem Faltenbalg 17 abgedichtet, der im Schnitt rechts und links von der Stange 15 zu sehen ist. Als Vorrichtung 44 eignet sich z.B. ein hydraulischer oder pneumatischer Arbeitszylinder.

Der Hohlraum 10a des Behälters 10 ist rechts oben (Fig. 1 und 2) durch eine feststehende Platte 18 und links oben durch ein verschiebbares Winkelprofil 19 verschlossen. Die Platte 18 ist direkt auf der rechten Seitenwand des Behälters 10 befestigt. Das Winkelprofil 19 ist mittels einer nur schematisch dargestellten linearen Antriebsvorrichtung 46 seitlich in Richtung eines Pfeiles 20 (Fig. 1) verschiebbar. Die Führung dieser Verschiebebewegung kann beispielsweise, wie dargestellt, über einen Führungsbolzen 21 erfolgen, der an der linken Seitenwand des Behälters 10 befestigt ist.

Der Verschluß des Hohlraums 10a wird durch zwei Elastomerprofile 22 und 23 abgedichtet. Das Profil 22 ist in eine geeignete Nut in der Stirnseite der Platte 18 eingelegt und wird durch die Stirnseite des Winkelprofils 19 in der in Fig. 1 dargestellten Weise angepreßt. Das Dichtungsprofil 23 ist in eine geeignete Nut in der linken Seitenwand des Behälters 10 eingelegt und wird durch einen vertikal verlaufenden Schenkel 19' des Winkelprofils 19 angepreßt. Der Anpreßdruck wird von der Vorrichtung 46 aufgebracht, welche das Winkelprofil 19 verschiebt. Alternativ können die Platte 18 und das Winkelprofil 19 mit einem geeigneten, lösungsmittelfesten Kunststoff überzogen sein, Dicke z.B. 0,5 mm, der dann im geschlossenen Zustand die Abdichtfunktionen übernimmt.

Das Bauteil 12 mit seinem Kapillarspalt 13 ist in Fig. 1 völlig unter die Oberfläche 24 des Fluids 11 eingetaucht dargestellt. Dies entspricht einem Zustand, bei dem nicht belackt wird, d.h. die Austrittsöffnung 40 des Bauteils 12 befindet sich unterhalb der Oberfläche 24 des Fluids 11.

In Fig. 2 ist derselbe Querschnitt des Behälters 10 mit sämtlichen Einbauten wie in Fig. 1 dargestellt, jedoch während eines Belackungsvorganges. Der aus Platte 18 und Winkelprofil 19 bestehende Verschluß des Hohlraums 10a ist dadurch geöffnet, daß das Minkelprofil 19 im Vergleich zur Darstellung der Fig. 1 in Richtung des Pfeiles 20 nach links verschoben ist. Das Bauteil 12 mit seinem Kapillarspalt 13 wurde durch eine-senkrechte Bewegung der Stange 15 in Richtung eines Pfeiles 28 nach oben bewegt. Dadurch ragen die messerartigen Fortsätze 43, 44 nunmehr über die Oberfläche 24 des Fluids im Behälter 10 hinaus und durch eine schmale Öffnung 48 zwischen Platte 18 und Winkelprofil 19 hindurch. Dies entspricht dem Zustand während eines Belackungsvorganges. Durch die schmale Form der messerartigen Fortsätze 43, 44 wird erreicht, daß die Öffnung 48 sehr schmal sein kann, was die Gefahr verringert, daß Verunreinigungen durch die Öffnung 48 in das Fluid 11 gelangen. Auch wird hierdurch die Verdunstung des Fluids 11 reduziert.

In Fig. 2 ist auch ein zu belackendes Substrat 29 (in Form einer Platte) während eines Belackungsvorganges dargestellt. Dieses Substrat 29 wird mit gleichförmiger Geschwindigkeit in Richtung eines Pfeiles 30 in sehr geringem Abstand (z.B. 0,2 ... 0,5 mm) über die Austrittsöffnung 40 des Kapillarspalts 13 hinweggeführt. Dabei scheidet sich durch Kapillarwirkung und Adhäsion eine sehr gleichförmige Lackschicht 31 auf der Unterseite 50 des Substrats 29 ab. Im nassen Zustand liegt die Dicke der Lackschicht 31 typischerweise im Bereich von 5 bis 50 µm.

In Fig. 3 ist ein Längsschnitt durch einen Teil des Behälters 10 und des Bauteils 12 während eines Belackungsvorganges dargestellt. Das Bauteil 12 ist, ebenso wie in der Darstellung der Fig. 2, in Richtung des Pfeiles 28 nach oben gefahren. An der Unterseite 50 des zu belackenden Substrats 29 scheidet sich eine gleichförmige Lackschicht 31 ab. Die Dicke dieser Schicht 31 ist zur Veranschaulichung stark übertrieben dargestellt.

Der Teillängsschnitt der Fig. 3 zeigt einen linken Abschnitt 52 des Behälters 10 sowie des Bauteils 12, und die zu dessen vertikalem Antrieb dienende Stange 15. Spiegelbildlich dazu gibt es auch am rechten Ende des Behälters 10 eine der Stange 15 entsprechende zweite Stange, die in Fig. 3 nicht dargestellt ist. Eine Spiegelebene ist symbolisch bei 54 dargestellt. Die gesamte Länge des Bauteils 12 kann, wie bereits erläutert, z.B. 50 bis 75 cm betragen, wobei die äußeren Randbereiche, wie in Fig. 3 dargestellt, nicht für die Belackung verwendet werden. Durch parallele Auf- und Abbewegungen der Stangen 15 wird sichergestellt, daß die Austrittsöffnung (Düse) 40 des Kapillarspalts 13 immer in der notwendigen, genau horizontalen Lage bleibt.

In Fig. 3 ist außerdem ein Überlaufrohr 32 im Schnitt dargestellt. Sobald nach Einschalten einer Pumpe 34 die Füllhöhe des Fluids 11 im Hohlraum 10a die Oberkante dieses Überlaufrohres 32 erreicht, beginnt dort Fluid abzufließen. Es gelangt durch das Überlaufrohr 32 in einen Ausgleichsbehälter 33, z.B. eine Vorratsflasche, welche z.B. 2,5 l des Fluids 11 enthält. Die Pumpe 34 ist über ein Rohr 34' an den Behälter 33 angeschlossen und saugt aus diesem Fluid 11 an. Von der Pumpe 34 gelangt das Fluid 11 über ein Feinstfilter 35 und eine Leitung 35a zurück in den Hohlraum 10a. Pumpe 34 und Filter 35 sind handelsübliche Komponenten und daher nur schematisch dargestellt.

Durch Umpumpen des Fluids 11 zwischen den Belackungs- bzw. Beschichtungsvorgängen wird dieses gereinigt, und sein Füllstand 24 im Behälter 10 wird konstant auf einer vorgegebenen Höhe gehalten. Beides ist für die Qualität des Belackungs- bzw. Beschichtungsvorgangs wichtig. Während des Belackungs- bzw. Beschichtungsvorgangs wird das Fluid 11 nicht durch das Filter 35 gepumpt, da eine Strömung im Behälter 10 das Belackungs- bzw. Beschichtungsergebnis negativ beeinflussen könnte. Bei der Belackung eines Substrats 29 werden gewöhnlich zwischen 1 und 3 ml des Fluids 11 verbraucht, wodurch der Flüssigkeitsspiegel 24 nur ganz wenig absinkt, z.B. um 0,1 bis 0,4 mm, was bei der Belackung nicht stört.

Innerhalb des Hohlraums 10a befindet sich außerdem ein Faltenbalg 25. Seine obere Abschlußplatte 56 ist über eine Stange 57, welche den Boden des Behälters 10 durchdringt, mit dem Kolben 58 eines Arbeitszylinders 60 verbunden, der mittels einer schematisch dargestellten Vorrichtung 62 betätigt werden kann.

Wird durch Betätigung der Vorrichtung 62 (diese erfolgt gewöhnlich durch eine zentrale Steuerung mittels eines nicht dargestellten Mikroprozessors) der Kolben 58 in Richtung eines Pfeiles 63 nach unten verschoben, so bewegt sich die obere Abschlußplatte 56 des Faltenbalgs 25 nach unten, und das Volumen des Faltenbalgs 25 wird verkleinert, wobei durch eine Öffnung 65 im Boden des Behälters 10 Luft nach unten entweichen kann. Dadurch sinkt der-Flüssigkeitsspiegel 24 im Behälter 10 rasch ab. Wird umgekehrt die obere Abschlußplatte 56 mittels des Arbeitszylinders 60 nach oben bewegt, so steigt der Flüssigkeitsspiegel 24 bis zu einem Maximalwert, der durch das Überlaufrohr 32 vorgegeben ist.
Somit kann durch entsprechende Steuerung der Vorrichtung 62 der Flüssigkeitsstand 24 im Behälter 10 rasch entsprechend den Bedürfnissen verändert werden.

### Arbeitsweise

Sobald ein zu belackendes Substrat 29 für den Beginn eines Belackungsvorganges positioniert ist, wird die Abdeckung des Behälters 10 geöffnet, indem das Winkelprofil 19 durch die Vorrichtung 46 nach links verschoben wird. Anschließend werden die messerartigen Fortsätze 43, 44 des Bauteils 12 nach oben bis auf einen sehr geringen Abstand von z.B. 0,05 mm unter die Vorderkante des zu belackenden Substrats 29 herangefahren. Da hierbei die Pumpe 34 abgeschaltet ist, sinkt der Flüssigkeitsspiegel 24 geringfügig ab, z.B. um 0,1 bis 0,5 mm, was aber nicht stört. Das geringe Absinken ist eine Folge davon, daß die aus dem Fluid 11 heraustauchenden messerartigen Fortsätze 43, 44 nur ein geringes Volumen haben, was hier sehr vorteilhaft ist. Durch die Bewegung des Bauteils 12 wird ein Kontakt hergestellt zwischen dem kleinen Fluidwulst einerseits, der von dem Tauchbad über der Austrittsöffnung 40 des Kapillarspalts 13 verblieben ist, und andererseits der vorderen Unterkante des zu belackenden Substrats 29. Nach der Herstellung dieses Kontakts wird der Abstand zwischen der Austrittsöffnung 40 des Bauteils 12 und dem zu belackenden bzw. zu beschichtenden Substrat 29 wieder etwas vergrößert, z.B. auf ca. 0,2 bis 0,5 mm. Damit wird der Kapillareffekt in Gang gesetzt, der das Fluid 11 entgegen der Schwerkraft mit gleichförmiger Geschwindigkeit durch den Kapillarspalt 13 nach oben transportiert. Jetzt wird das Substrat 29 mit gleichförmiger Geschwindigkeit waagerecht in Richtung des Pfeiles 30 in Bewegung gesetzt. Hierbei wird eine gleichförmige, dünne Fluidschicht 31 durch den Kapillarspalt 13 hindurch auf der Unterseite des Substrats 29 abgeschieden.

Ist die (nicht dargestellte) Endkante des zu belackenden Substrats 29 erreicht, so wird der Faltenbalg 25 in der bereits beschriebenen Weise rasch verkleinert, z.B. innerhalb einer Sekunde. Dadurch sinkt der Flüssigkeitsspiegel 24 im Hohlraum 10a rasch ab. (Die Pumpe 34 steht hierbei still.) Auf diese Weise entsteht im Kapillarspalt 13 ein Unterdruck, der das im Kapillarspalt 13 enthaltene Fluid 11 nach unten saugt. Dies bewirkt, daß die Fluidabscheidung auf der Unterseite der Platte 29 plötzlich beendet und eine unerwünschte Wulstbildung an der (nicht dargestellten) Endkante des Substrats 29 sicher verhindert wird. Durch die äußerst schmale Form der messerartigen Fortsätze 43, 44 im Bereich der Düse 40 wird erreicht, daß sich an der Endkante des Substrats 29 keine Lackwülste oder dergleichen bilden.

Anschließend wird das Bauteil 12 wieder nach unten in den Behälter 10 zurückgefahren, und die Abdeckung aus Platte 18 und Winkelprofil 19 wird wieder geschlossen, um den Innenraum des Behälters 10 nach außen hin luftdicht abzuschließen und eine Verdunstung des Fluids 11 im Hohlraum 10a zu verhindern.

Nach dem Schließen der Abdeckung (durch Verschieben des Winkelprofils 19 nach rechts) wird die Pumpe 34 eingeschaltet. Das bei der Belackung verbrauchte Fluid 11 wird somit wieder dem Hohlraum 10a zugeführt. Sobald die notwendige Füllhöhe des Fluids 11 erreicht ist, beginnt dieses wieder durch das Überlaufrohr 32 in den Ausgleichsbehälter 33 abzufließen. Durch den Kreislauf wird das Fluid 11 gefiltert. Der Zeitraum, während dessen die Pumpe 34 eingeschaltet ist, beträgt im allgemeinen nur wenige Sekunden. Wird jedoch festgestellt, daß das Fluid 11 verunreinigt ist, so kann man die Pumpe 34 auch längere Zeit laufen lassen, um das Fluid mittels des Filters 35 zu reinigen. Der Vorratsbehälter 33 muß von Zeit zu Zeit ersetzt werden, wenn das Fluid in ihm verbraucht ist. Ein großer Vorteil der Erfindung ist der sehr sparsame Verbrauch an Fluid, z.B. nur etwa 1 bis 3 ml pro zu beschichtender Platte 29. - Als Vorratsbehälter 33 kann die Flasche verwendet werden, in der das Fluid 11 von seinem Hersteller geliefert wird.

Naturgemäß sind vielfache Abwandlungen und Modifikationen möglich. Z.B. könnte das Teil 12 auch durch eine Drehbewegung um seine Längsachse aus der Stellung gemäß Fig. 2 in seine untergetauchte Stellung gebracht werden. Eine vertikale Verschiebung des Bauteils 12 wird jedoch derzeit bevorzugt, um unerwünschte, unsymmetrische Strömungsvorgänge im Fluid während der Belackung nach Möglichkeit zu vermeiden.

Eine erfindungsgemäße Vorrichtung kann einen Teil einer größeren Belackungsanlage bilden, wie sie z.B. in PCT/DE93/00777 dargestellt ist. Auf den Inhalt dieser PCT-Anmeldung wird deshalb zur Vermeidung von Längen ausdrücklich Bezug genommen.

Die Fig. 4 bis 10 zeigen eine bevorzugte Ausführungsform einer erfindungsgemäßen Vorrichtung 100. Gleiche Teile wie in den Fig. 1 bis 3 werden mit denselben Bezugszeichen bezeichnet wie dort, aber um die Zahl 100 erhöht, also z.B. 113 statt 13.

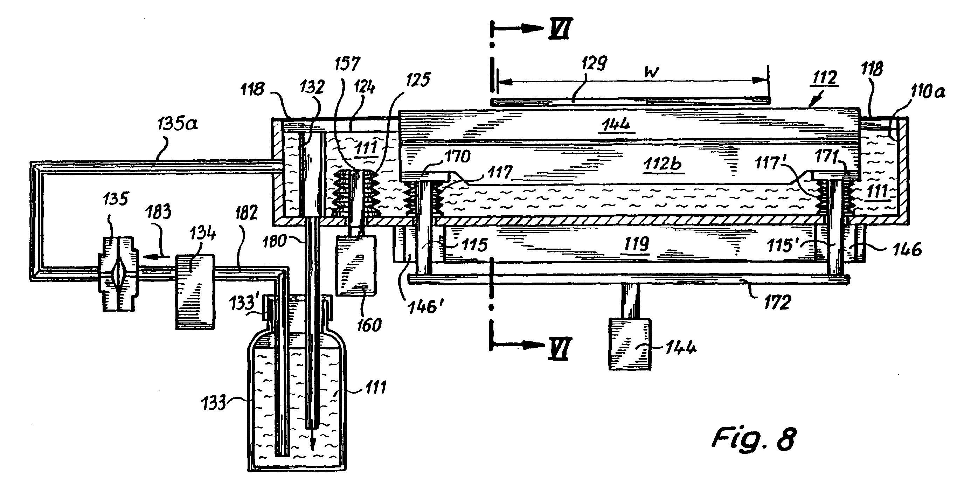

Fig. 4 zeigt die Vorrichtung 100 im Längsschnitt und in raumbildlicher Darstellung. Diese Vorrichtung hat einen länglichen, trogartigen Behälter 110, dessen Boden mit 110' bezeichnet ist. Sein Hohlraum 110a ist, wie in Fig. 8 dargestellt, bis zur Höhe eines Überlaufrohres 132 mit einem Fluid 111 gefüllt. Der Fluidspiegel ist in Fig. 8 mit 124 bezeichnet.

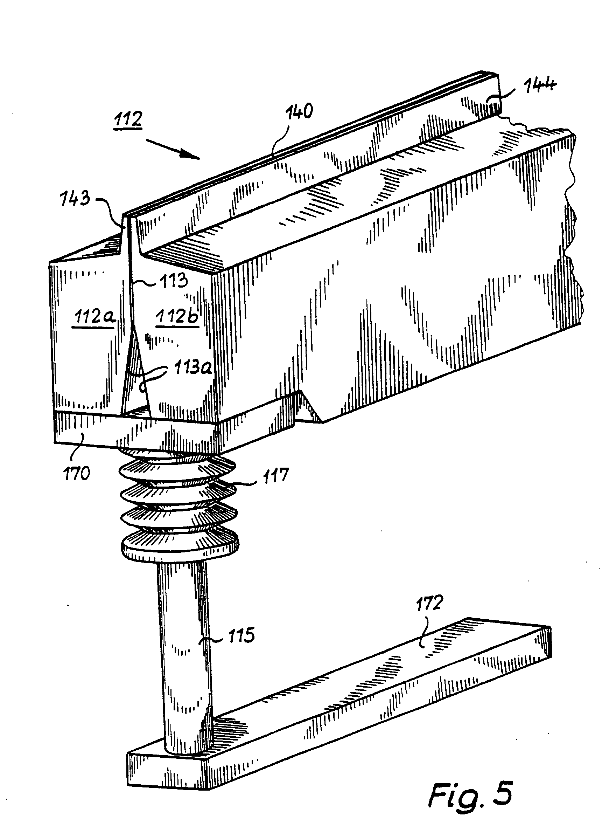

Im Behälter 110 befindet sich ein längliches Bauteil 112, das gemäß Fig. 5 aus zwei symmetrischen Hälften 112a, 112b zusammengesetzt ist, die durch einen Kapillarspalt 113 voneinander getrennt sind. Dieser Kapillarspalt 113 hat gemäß Fig. 7 eine Breite dl, die je nach verwendetem Fluid 111 ca. 0,1 bis 0,8 mm beträgt. Der Kapillarspalt 113 erweitert sich an seinem unteren Bereich zu einer im Querschnitt trichterförmigen Erweiterung 113a, die in den Fig. 4, 5 und 6 dargestellt ist. Sie erleichtert die Zufuhr des Fluids 111 zum Kapillarspalt 113.

Wie die Fig. 4, 5, 6 und 8 besonders gut zeigen, sind die symmetrischen Hälften 112a, 112b in ihrem Mittelbereich in vertikaler Richtung breiter ausgeführt, um eine Durchbiegung zu vermeiden. An ihren beiden Enden sind sie weniger hoch, und dort sind sie in geeigneter Weise, z.B. mittels (nicht dargestellter) Schrauben auf Montageplatten 170 bzw. 171 befestigt, die ihrerseits mit einer zylindrischen Stange 115 bzw. 115' verbunden sind. Diese Stangen durchdringen den Boden 110' des Behälters 110 und sind an ihren unteren Enden durch einen Querverbinder 172 miteinander verbunden, und dieser ist mittels einer Vorrichtung 144 in vertikaler Richtung verschiebbar, wodurch das Bauteil 112 gehoben und gesenkt werden kann, wie das anhand der Fig. 1 und 2 für das Bauteil 12 bereits ausführlich beschrieben wurde. Die Vorrichtung 144 kann ein beliebiger Linearantrieb sein, z.B. ein Pneumatikzylinder oder ein elektrischer Linearantrieb.

Die Stangen 115, 115' sind mittels Faltenbälgen 117, 117' in der dargestellten Weise abgedichtet, ebenso, wie in den Fig. 1 bis 3 anhand des Faltenbalgs 17 bereits auführlich erläutert.

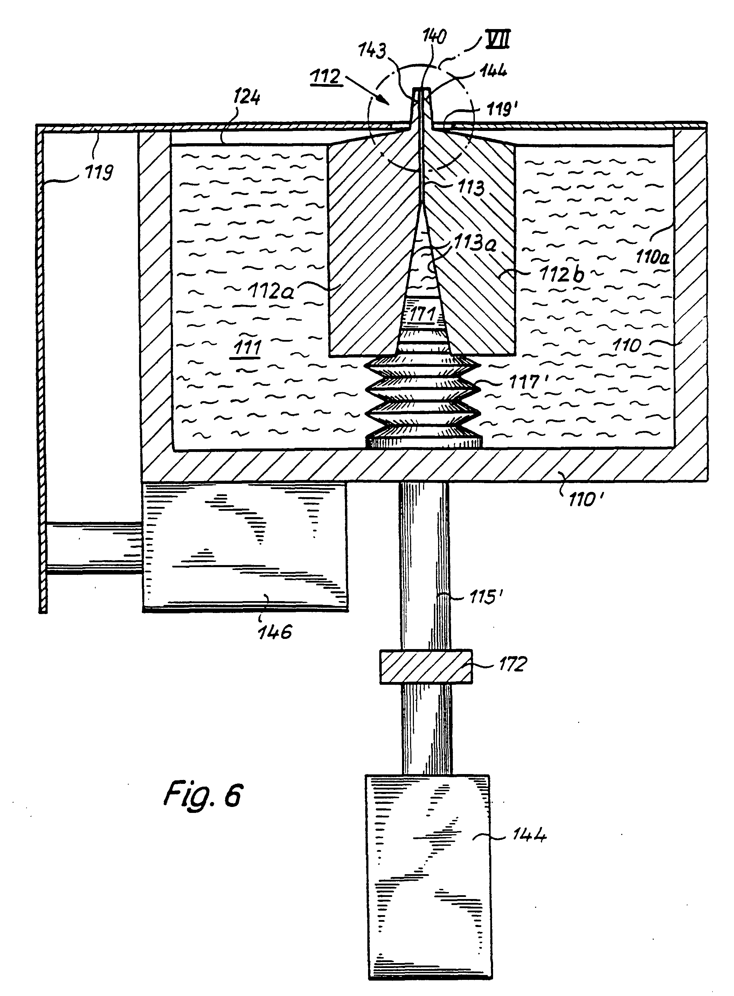

Wie die Fig. 5 und 6 besonders gut zeigen, haben die Hälften 112a, 112b des länglichen Körpers 112 an ihren oberen Enden jeweils einen messerartigen Fortsatz 143 bzw. 144, der im wesentlichen vertikal nach oben ragt. Jeder dieser Fortsätze 143, 144 endet oben in einer schmalen, im Betrieb waagerechten Fläche 177 bzw. 178 (Fig. 7), in welcher der Kapillarspalt 113 als Öffnung 140 mündet. Diese Öffnung 140 und die sie umgebenden Flächen 177, 178 können auch als Düse bezeichnet werden.

Die Fläche 177 hat gemäß Fig. 7 eine Breite d₂, welche zwischen 0,1 und 0,5 mm liegt und bevorzugt 0,3 mm beträgt. Die Fläche 178 hat eine Breite d₃ (Fig. 7), die zwischen 0,1 und 0,5 mm liegt und bevorzugt 0,3 mm beträgt. Der Vorteil dieser schmalen Flächen 177, 178 liegt darin, daß durch sie die Entstehung eines Fluidwulstes an der rückwärtigen Kante eines zu beschichtenden Substrats 129 weitgehend vermieden werden kann. Ein solches Substrat ist in Fig. 8 dargestellt. Seine Breite W ist kleiner als die Länge des Bauteils 12, d.h. für eine gleichförmige Beschichtung wird nur der mittlere Längenbereich W des Bauteils 112 ausgenutzt. In den Randbereichen könnten Diskontinuitäten der Fluidschicht (31 in den Fig. 1 bis 3) entstehen.

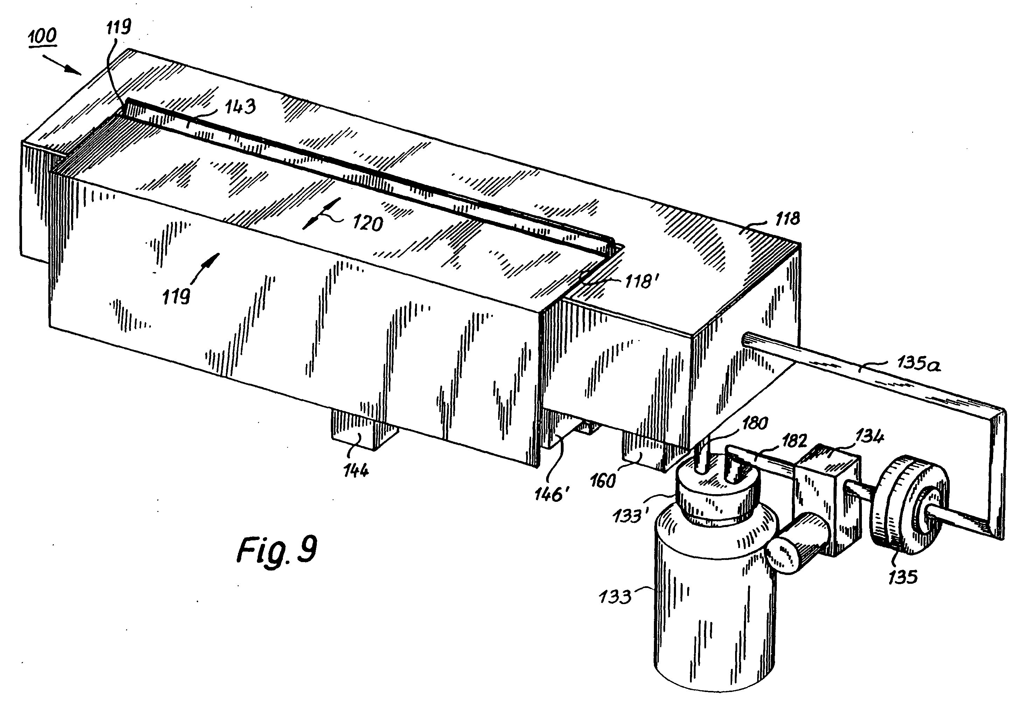

Wie man Fig. 9 entnimmt, ist der größte Teil der Oberseite des Behälters 110 durch eine Abdeck- und Abdichtplatte 118 überdeckt. Diese hat eine rechteckförmige Aussparung 118', und in diese ist eine verschiebbare Winkelplatte 119 eingepaßt, die dort in Richtung eines Pfeiles 120 in horizontaler Richtung verschiebbar ist. Wird sie in Fig. 9 nach vorne verschoben, so bildet sie eine Öffnung 119', durch welche die messerartigen Fortsätze 143, 144 für einen Belackungsvorgang nach oben geschoben werden können. Wird die Winkelplatte 119 in Fig. 9 nach hinten verschoben, so schließt sie die Öffnung 119' vollständig und dichtend ab. Hierzu können beide Platten 118 und 119 mit einem lösungsmittelfesten Kunststoff (nicht dargestellt) überzogen sein, der z.B. 0,5 mm dick ist und der an den Rändern die gewünschte Abdichtung bewirkt.

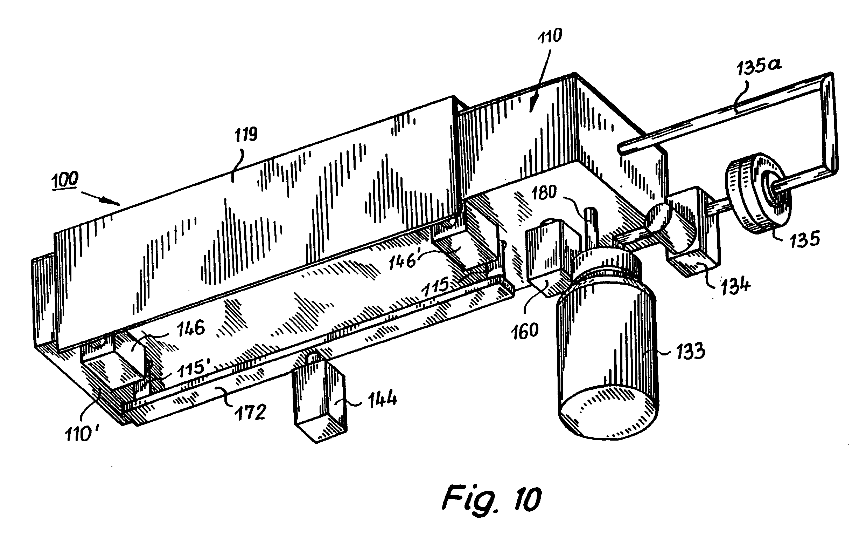

Zum horizontalen Verschieben der Winkelplatte 119 dienen zwei lineare Antriebsglieder 146, 146' (Fig. 10), die synchron miteinander betätigt werden, um eine gleichmäßige Verschiebung der Winkelplatte 119 zu erreichen.

Im Hohlraum 110a des Behälters 110 befindet sich auch ein Faltenbalg 125, dessen Volumen mittels eines Betätigungsgliedes 160 verändert werden kann. Wird dieses Volumen dadurch verändert, daß eine Betätigungsstange des Faltenbalgs 125 in Richtung nach unten bewegt wird, so bewirkt dies eine rasche Absenkung des Fluidniveaus 124 im Behälter 110, wodurch das Fluid im Kapillarspalt 113 nach unten gesaugt und ein Belackungsvorgang beendet wird. Wird die Stange 157 nach oben bewegt, so steigt das Fluidniveau 124 rasch an.

An das Überlaufrohr 132 ist ein nach unten führendes Rohr 180 angeschlossen, das durch einen Deckel 133' in das Innere einer Vorratsflasche 133 für das Fluid 111 führt. Aus dieser Flasche 133 führt, ebenfalls durch den Deckel 133', ein Saugrohr 182 zu einer Pumpe 134, welche nur betätigt werden kann, wenn kein Belackungsvorgang stattfindet. Diese Pumpe 134 fördert Fluid in Richtung eines Pfeiles 183 (Fig. 8) zu einem Feinstfilter 135, und von diesem durch eine Leitung 135a zurück zum Innenraum 110a des Behälters 110.

Ist die Winkelplatte 119 in ihrem (nicht dargestellten) geschlossenen Zustand, in dem sie die Oberseite des Behälters 10 hermetisch abschließt, so kann die Pumpe 134 betätigt werden. Sie pumpt dann Fluid 111 aus dem Vorratsbehälter 133 durch das Feinstfilter 135 in den Hohlraum 110a des Behälters 110 und füllt diesen dadurch bis zur Höhe des Überlaufrohres 132 (Fig. 8) auf. (Bei einem Belackungsvorgang sinkt das Fluidniveau 124 geringfügig ab, da für die Belackung eine kleine Menge an Fluid verbraucht wird.)

### Arbeitsweise

Sobald ein zu belackendes Substrat 129 für den Beginn eines Belackungsvorganges positioniert ist, wird die Abdeckung des Behälters 110 geöffnet, indem die Winkelplatte 119 durch die beiden Vorrichtungen 146, 146' in Öffnungsrichtung verschoben wird. Anschließend werden die messerartigen Fortsätze 143, 144 des Bauteils 112 mittels des Antriebs 144 nach oben bis auf einen sehr geringen Abstand von z.B. 0,05 mm unter die Vorderkante des zu belackenden Substrats 129 herangefahren. Dadurch wird ein Kontakt hergestellt zwischen dem kleinen Fluidwulst einerseits, der von dem Fluid 111 im Behälter 110 über der Austrittsöffnung 140 des Kapillarspalts 113 verblieben ist, und andererseits der vorderen Unterkante des zu belackenden Substrats 129. Nach der Herstellung dieses Kontakts wird der Abstand zwischen der Austrittsöffnung 140 des Bauteils 12 und dem zu belackenden bzw. zu beschichtenden Substrat 129 wieder etwas vergrößert, z.B. auf ca. 0,2 bis 0,5 mm. Damit wird der Kapillareffekt in Gang gesetzt, der das Fluid 111 aus dem Behälter 110 entgegen der Schwerkraft mit gleichförmiger Geschwindigkeit durch den Kapillarspalt 113 nach oben transportiert. Jetzt wird das Substrat 129 mit gleichförmiger Geschwindigkeit waagerecht in Bewegung gesetzt, wie bei Fig. 2 ausführlich beschrieben. Hierbei wird eine gleichförmige, dünne Fluidschicht durch den Kapillarspalt 113 hindurch auf der Unterseite des Substrats 129 abgeschieden. Diese Schicht hat im feuchten Zustand gewöhnlich eine Dicke zwischen 5 und 50 µm.

Ist die (nicht dargestellte) Endkante des zu belackenden Substrats 129 erreicht, so wird der Faltenbalg 125 in der bereits beschriebenen Weise rasch verkleinert, z.B. innerhalb einer Sekunde. Dadurch sinkt der Flüssigkeitsspiegel 124 im Hohlraum 110a rasch ab. (Die Pumpe 134 steht hierbei still.) Auf diese Weise entsteht im Kapillarspalt 113 ein Unterdruck, der das dort befindliche Fluid 111 nach unten absaugt. Dies bewirkt, daß die Fluidabscheidung auf der Unterseite des Substrats 129 plötzlich beendet und eine unerwünschte Wulstbildung an der (nicht dargestellten) Endkante des Substrats 129 sicher verhindert wird. Durch die äußerst schmale Form der messerartigen Fortsätze 143, 144 im Bereich der Öffnung 140 wird erreicht, daß sich an der Endkante des Substrats 129 keine Lackwülste oder dergleichen bilden.

Anschließend wird das Bauteil 112 mittels des Antriebs 144 wieder nach unten in den Behälter 110 zurückgefahren, wo es vollständig in das Fluid 111 untergetaucht wird, und die Öffnung 119' wird durch die Winkelplatte 119 wieder hermetisch verschlossen, um den Innenraum des Behälters 110 nach außen abzudichten und so eine Verdunstung des Fluids 111 im Hohlraum 110a zu verhindern.

Nach dem Verschließen der Öffnung 119' wird die Pumpe 134 eingeschaltet, und dadurch wird das bei einem Belackungsvorgang verbrauchte Fluid 111 wieder dem Hohlraum 110a zugeführt. Sobald dort die richtige Füllhöhe erreicht ist, beginnt das Fluid 111 wieder durch das Überlaufrohr 132 in den Vorrats- und Ausgleichsbehälter 133 abzufließen. Durch den Kreislauf wird das Fluid 111 durch das Feinstfilter 135 gefiltert. Die Pumpe wird zu diesem Zwecke gewöhnlich nur wenige Sekunden eingeschaltet, kann jedoch zwecks Reinigung des Fluids 111 auch länger eingeschaltet werden. Der Vorratsbehälter 133 wird durch eine neue Flasche ersetzt, wenn das in ihm befindliche Fluid 111 verbraucht ist. Hierzu wird eine neue Flasche 133 von unten an den feststehenden Deckel 133' angeschraubt. Ein großer Vorteil der Erfindung ist der äußerst sparsame Verbrauch von Fluid 11 und der Wegfall der Notwendigkeit, Fluidreste zu entsorgen.

Naturgemäß sind im Rahmen der Erfindung vielfache Abwandlungen und Modifikationen möglich. So kann naturgemäß der Verschluß des Behälters 110 auf verschiedene Arten bewerkstelligt werden, z.B. auch durch Aufsetzen eines Deckels von oben. Auch kann man alternativ das Substrat 129 von oben her an die Öffnung 140 des Bauteils 112 heranführen, statt umgekehrt diese Öffnung 140 an die Unterseite des Substrats 129 heranzuführen.

Ebenso könnte statt des Faltenbalgs 125 z.B. eine Pumpe vorgesehen sein, welche rasch Fluid 111 aus dem Behälter 110 absaugt, um das Fluidniveau 124 rasch abzusenken, wobei diese Pumpe ganz einfach als Hohlraum eines Arbeitszylinders ausgebildet sein kann. Dies wäre analog dem Vorgang, wie man vor einer Injektion die zu injizierende Flüssigkeit in eine Injektionsspritze ansaugt. In beiden Fällen (Pumpe oder Zylinder) kann die Flüssigkeit anschließend wieder in den Behälter 110 zurückgepumpt werden, z.B. durch Umkehr der Förderrichtung dieser (nicht dargestellten) Pumpe.

## Patentansprüche

1. Vorrichtung zur Belackung oder Beschichtung eines Substrats (29; 129) mittels eines einen Kapillarspalt (13; 113) aufweisenden Bauteils (12; 112),
mit einem Lack oder Beschichtungsflüssigkeit - im folgenden Fluid (11; 111) genannt - enthaltenden Behälter (10; 110), in welchem das Bauteil (12; 112) so angeordnet ist, dass der Kapillarspalt (13; 113) mit dem Fluid (11; 111) im Behälter in Verbindung steht und dieses Fluid dem Kapillarspalt (13; 113) zuführbar ist,
und mit Mitteln (44; 144) zur Bewegung der Austrittsöffnung (40; 140) des Kapillarspalts (13; 113) relativ zum Behälter (10; 110) in Höhenrichtung (16, 28).

2. Vorrichtung nach Anspruch 1, bei welcher die Austrittsöffnung (40; 140) des Kapillarspalts (13; 113) durch eine in Höhenrichtung erfolgende Bewegung vollständig in das Fluid (11; 111) eintauchbar ist (Fig. 1).

3. Vorrichtung nach Anspruch 1 oder 2, bei welcher die Austrittsöffnung (40; 140) des Kapillarspalts (13; 113) durch eine in Höhenrichtung erfolgende Bewegung an die Unterseite (50) eines Substrats (29; 129) heranführbar ist, oder umgekehrt.

4. Vorrichtung nach einem oder mehreren der Ansprüche 1 bis 3, bei welcher die Bewegung des Bauteils (12; 112) als Vertikalbewegung (16) desselben ausgebildet ist.

5. Vorrichtung nach einem oder mehreren der Ansprüche 1 bis 4, bei welcher der Behälter (10; 110) nach Art einer Rinne oder eines Troges ausgebildet ist.

6. Vorrichtung nach einem oder mehreren der Ansprüche 1 bis 5, bei welcher eine Verschlussvorrichtung (19; 119) für den Behälter (10; 110) vorgesehen ist, um diesen bei Nichtbenutzung der Vorrichtung (100) nach aussen hin zu verschliessen.

7. Vorrichtung nach Anspruch 6, bei welcher die Verschlussvorrichtung ein seitlich verschiebbares, oberes Verschlussglied (19; 119) für den Behälter (10; 110) aufweist.

8. Vorrichtung nach einem oder mehreren der vorhergehenden Ansprüche, bei welcher dem Behälter (10; 110) ein Überlauf (32; 132) zugeordnet ist, um den Füllstand (24; 124) des Fluids (11; 111) im Behälter (10; 110) auf konstantem Niveau zu halten.

9. Vorrichtung nach einem oder mehreren der vorhergehenden Ansprüche, bei welcher eine Pumpe (34; 134) vorgesehen ist, um bei einer Beschichtung verbrauchtes Fluid (11; 111) aus einem Vorratsbehälter (33; 133) dem Hohlraum (10a; 110a) des Behälters (10; 110) zuzuführen.

10. Vorrichtung nach einem oder mehreren der vorhergehenden Ansprüche, bei welcher eine Filtervorrichtung (35; 135) und eine Pumpe (34; 134) vorgesehen sind, um im Behälter (10; 110) befindliches Fluid (11; 111) im Umlauf zu filtrieren.

11. Vorrichtung nach Anspruch 10, bei welcher die Filtrierung während eines Beschichtungs- oder Belackungsvorganges unterbrochen ist.

12. Vorrichtung nach einem oder mehreren der vorhergehenden Ansprüche, bei welcher Mittel (25; 125) vorgesehen sind, um das Niveau (24; 124) des Fluids im Behälter rasch abzusenken, insbesondere am Ende eines Belackungs- oder Beschichtungsvorgangs.

13. Vorrichtung nach Anspruch 12, bei welcher in dem im Behälter (10; 110) befindlichen Fluid (11; 111) ein Bauteil (25; 125) angeordnet ist, dessen Volumen veränderbar ist.

14. Vorrichtung nach Anspruch 13, bei welcher das Bauteil als Balg (25; 125) ausgebildet ist.

15. Vorrichtung nach Anspruch 14, bei welcher das Volumen des Balgs (25; 125) durch einen Linearantrieb (60; 160) veränderbar ist.

16. Vorrichtung nach einem oder mehreren der vorhergehenden Ansprüche, bei welcher der Kapillarspalt (13; 113) des Bauteils (12; 112) im Bereich seiner Austrittsöffnung (40; 140) durch zwei messerartige Teile (43, 44; 143, 144) gebildet ist, zwischen welchen sich der Kapillarspalt (13; 113) erstreckt.

17. Vorrichtung nach Anspruch 16, bei welcher die Grösse einer an der Oberseite des Behälters (12; 112) vorgesehenen Öffnung (119') an die Abmessungen der messerartigen Teile (143, 144) angepasst ist, um diese mit geringem Abstand zu umgeben.

18. Vorrichtung nach Anspruch 16 oder 17, bei welcher die messerartigen Teile (43, 44; 143, 144) jeweils im Bereich der Austrittsöffnung (40; 140) eine horizontale Fläche (177 bzw. 178) aufweisen, deren Breite (d₂ bzw. d₃) jeweils im Bereich von 0,1...0,5 mm und bevorzugt bei etwa 0,2 mm liegt.

19. Verfahren zum Belacken oder Beschichten eines Substrats mittels eines über einen Kapillarspalt zugeführten Fluids, mit folgenden Schritten:
a) Zu Beginn eines Beschichtungs- oder Belackungsvorgangs wird die Austrittsöffnung des Kapillarspalts eng an die Unterseite des Substrats herangeführt, so dass das Fluid an der Austrittsöffnung in Kontakt mit dieser Unterseite kommt;
b) anschliessend wird der Abstand zwischen dieser Austrittsöffnung und der Unterseite des Substrats auf einen für die Belackung oder Beschichtung ausreichenden Wert vergrössert.

20. Verfahren nach Anspruch 19, bei welchem nach dem Schritt b) das Substrat über die Austrittsöffnung des Kapillarspalts hinweggeführt wird, oder umgekehrt.

## Claims

1. Device for lacquering or coating a substrate (29; 129) by means of a component (12; 112) having a capillary gap (13; 113), with a container (10; 110) which contains a lacquer or coating liquid - termed fluid (11; 111) in the following - and in which the component (12; 112) is so arranged that the capillary gap (13; 113) stands in connection with the fluid (11; 111) in the container and this fluid can be fed to the capillary gap (13; 113), and with means (44; 144) for movement of the outlet opening (40; 140) of the capillary gap (13; 113) relative to the container (10; 110) in height direction (16, 28).

2. Device according to claim 1, in which the outlet opening (40; 140) of the capillary gap (13; 113) is completely immersible in the fluid (11; 111) by a movement carried out in height direction (Fig. 1).

3. Device according to claim 1 or 2, in which the outlet opening (40; 140) of the capillary gap (13; 113) can be guided to the underside (50) of a substrate (29; 129) or conversely by a movement carried out in height direction.

4. Device according to one or more of claims 1 to 3, in which the movement of the component (12; 112) is configured as a vertical movement (16) thereof.

5. Device according to one or more of claims 1 to 4, in which the container (10; 110) is constructed in the form of a channel or a trough.

6. Device according to one or more of claims 1 to 5, in which a closure device (19; 119) for the container (10; 110) is provided so as to close this off towards the outside when the device (100) is not in use.

7. Device according to claim 6, in which the closure device comprises a laterally displaceable, upper closure element (19; 119) for the container (10; 110).

8. Device according to one or more of the preceding claims, in which the container (10; 110) is associated with an overflow (32; 132) so as to maintain the filling state (24; 124) of the fluid (11; 111) in the container (10; 110) at a constant level.

9. Device according to one or more of the preceding claims, in which a pump (34; 134) is provided in order to feed fluid (11; 111), which is consumed during coating, from a storage container (33; 133) to the cavity (10a; 110) of the container (10; 110).

10. Device according to one or more of the preceding claims, in which a filter device (35; 135) and a pump (34; 134) are provided in order to filter fluid (11; 111), which is disposed in the container (10; 110), in circulation.

11. Device according to claim 10, in which the filtering is interrupted during a coating or lacquering process.

12. Device according to one or more of the preceding claims, in which means (25; 125) are provided in order to rapidly lower the level (24; 124) of the fluid in the container, particularly at the end of a lacquering or coating process.

13. Device according to claim 12, in which a component (25; 125), the volume of which is variable, is arranged in the fluid (11; 111) disposed in the container (10; 110).

14. Device according to claim 13, in which the component is constructed as a bellows (25; 125).

15. Device according to claim 14, in which the volume of the bellows (25; 125) is variable by a linear drive (60; 160).

16. Device according to one or more of the preceding claims, in which the capillary gap (13; 113) of the component (12; 112) is formed in the region of its outlet opening (40; 140) by two knife-like parts (43, 44; 143, 144), between which the capillary gap (13; 113) extends.

17. Device according to claim 16, in which the size of an opening (119') provided at the upper side of the container (12; 112) is matched to the knife-like parts (143, 144) so as to surround these at a small spacing.

18. Device according to claim 16 or 17, in which the knife-like parts (43, 44; 143, 144) each have in the region of the outlet opening (40; 140) a respective horizontal surface (177 or 178), of which the width (d₂ or d₃) each lies in the region of 0.1 ... 0.5 mm and preferably at about 0.2 mm.

19. Method of lacquering or coating a substrate by means of a fluid fed by way of a capillary gap, with the following steps:
a) at the start of a coating or lacquering process the outlet opening of the capillary gap is led closely to the underside of the substrate so that the fluid at the outlet opening comes into contact with this underside; and
b) subsequently the spacing between this outlet opening and the underside of the substrate is enlarged to a value sufficient for the lacquering or coating.

20. Method according to claim 19, in which the substrate is guided away, or conversely, over the outlet opening of the capillary gap after the step b).

## Revendications

1. Dispositif pour le laquage ou le recouvrement d'un substrat (29 ; 129) au moyen d'un composant (12 ; 112) présentant une fente capillaire (13 ; 113) avec un récipient (10 ; 110) contenant une laque ou un liquide de recouvrement - appelé ci-après fluide (11 ; 111) - , dans lequel le composant (12 ; 112) est disposé de façon que la fente capillaire (13 ; 113) soit en liaison avec le fluide (11 ; 111) dans le récipient et que ce fluide puisse être amené à la fente capillaire (13 ; 113),
et avec des moyens (44 ; 144) pour déplacer l'ouverture de sortie (40 ; 140) de la fente capillaire (13 ; 113) relativement au récipient (10 ; 110) dans le sens de la hauteur (16, 28).

2. Dispositif selon la revendication 1, où l'ouverture de sortie (40 ; 140) de la fente capillaire (13 ; 113) peut être plongée par un mouvement ayant lieu dans le sens de la hauteur complètement dans le fluide (11 ; 111) (figure 1).

3. Dispositif selon la revendication 1 ou 2, où l'ouverture de sortie (40 ; 140) de la fente capillaire (13 ; 113) peut être amenée par un mouvement ayant lieu dans le sens de la hauteur au côté inférieur (50) d'un substrat (29 ; 129) ou inversement.

4. Dispositif selon l'une ou plusieurs des revendications 1 à 3, où le mouvement du composant (12 ; 112) est réalisé comme mouvement vertical (16) de celui-ci.

5. Dispositif selon l'une ou plusieurs des revendications 1 à 4, où le récipient (10 ; 110) est réalisé à la manière d'une rainure ou d'une auge.

6. Dispositif selon l'une ou plusieurs des revendications 1 à 5, où un dispositif de fermeture (19 ; 119) est prévu pour le récipient (10 ; 110) pour fermer celui-ci vers l'extérieur lors d'une non-utilisation du dispositif (100).

7. Dispositif selon la revendication 6, où le dispositif de fermeture présente un organe de fermeture supérieur (19, 119) déplaçable latéralement pour le récipient (10 ; 110).

8. Dispositif selon l'une ou plusieurs des revendications précédentes, où il est associé au récipient (10 ; 110) un trop-plein (32 ; 132) pour maintenir le niveau de remplissage (24 ; 124) du fluide (11 ; 111) dans le récipient (10 ; 110) à un niveau constant.

9. Dispositif selon l'une ou plusieurs des revendications précédentes, où une pompe (34 ; 134) est prévue pour ramener du fluide (11 ; 111) utilisé lors d'un recouvrement d'un réservoir de stockage (33 ; 133) à l'espace creux (10a ; 110a) du récipient (10 ; 110).

10. Dispositif selon l'une ou plusieurs des revendications précédentes, où un dispositif filtrant (35; 135) et une pompe (34 ; 134) sont prévus pour filtrer en circuit le fluide (11 ; 111) se trouvant dans le récipient (10 ; 110).

11. Dispositif selon la revendication 10, où la filtration est interrompue pendant une opération de recouvrement ou de laquage.

12. Dispositif selon l'une ou plusieurs des revendications précédentes, où des moyens (25 ; 125) sont prévus pour baisser rapidement le niveau (24 ; 124) du fluide dans le récipient, notamment à la fin d'une opération de laquage ou de recouvrement.

13. Dispositif selon la revendication 12, où il est disposé dans le fluide (11 ; 111) se trouvant dans le récipient (10 ; 110), un composant (25 ; 125) à volume variable.

14. Dispositif selon la revendication 13, où le composant est réalisé comme soufflet (25 ; 125).

15. Dispositif selon la revendication 14, où le volume du soufflet (25 ; 125) peut être modifié par un organe d'entraînement linéaire (60 ; 160).

16. Dispositif selon l'une ou plusieurs des revendications précédentes, où la fente capillaire (13 ; 113) du composant (12 ; 112), au voisinage de son ouverture de sortie (40 ; 140) est formée par deux parties semblables à des couteaux (43, 44 ; 143, 144) entre lesquelles s'étend la fente capillaire (13 ; 113).

17. Dispositif selon la revendication 16, où la grandeur d'une ouverture (119') prévue au côté supérieur du récipient (12 ; 112) est adaptée aux dimensions des parties semblables à des couteaux (143, 144) pour entourer celles-ci avec un faible écart.

18. Dispositif selon la revendication 16 ou 17, où les parties semblables à des couteaux (43, 44 ; 143, 144) présentent respectivement au voisinage de l'ouverture de sortie (40 ; 140) une face horizontale (177 respectivement 178) dont la largeur (d₂ respectivement d₃) se situe dans la plage de 0,1 ... 0,5 mm et est de préférence d'environ 0,2 mm.

19. Procédé pour le laquage ou le recouvrement d'un substrat au moyen d'un fluide amené par une fente capillaire, avec les étapes suivantes :
a) au début d'une opération de recouvrement ou de laquage, l'ouverture de sortie de la fente capillaire est amenée étroitement au côté inférieur du substrat de telle sorte que le fluide à l'ouverture de sortie vient en contact avec ce côté inférieur ;
b) ensuite, l'écart entre cette ouverture de sortie et le côté inférieur du substrat est agrandi à une valeur suffisante pour le laquage ou le recouvrement.

20. Procédé selon la revendication 19, où après l'étape b) le substrat est amené à passer au-dessus de l'ouverture de sortie de la fente capillaire, ou inversement.
